# EUROPÄISCHE PATENTSCHRIFT

(11) **EP 2 479 893 B1**
(45) Veröffentlichungstag und Bekanntmachung des Hinweises auf die Patenterteilung: **20.06.2018**
(21) Anmeldenummer: 11151461.8
(22) Anmeldetag: 19.01.2011
(51) Int. Cl.: H03K 17/955, B60R 19/48

(54) **Kapazitiver Annäherungssensor**
Capacitive proximity sensor
Capteur de rapprochement capacitif

(43) Veröffentlichungstag der Anmeldung: 25.07.2012
(73) Patentinhaber: Huf Hülsbeck & Fürst GmbH & Co. KG, 42551 Velbert (DE)
(72) Erfinder: Berthold, Sieg, 46240 Bottrop (DE)
(74) Vertreter: Zenz Patentanwälte Partnerschaft mbB

(56) Entgegenhaltungen:
- EP-A1- 1 600 336
- EP-A1- 2 112 476
- DE-A1-102008 005 783
- DE-T2- 60 006 824

## Beschreibung

Die Erfindung betrifft einen kapazitiven Annäherungssensor, der hinter einer Verkleidung aus einem Isolatormaterial (einem Dielektrikum) angeordnet ist und zur Erfassung der Annäherung eines Objekts (beispielsweise eines Körperteils eines Bedieners) dient, das sich in einem Erfassungsraum vor der Verkleidung befindet, wobei der Annäherungssensor eine Sensorelektrodenanordnung mit wenigstens einer Sensorelektrode und eine mit der Sensorelektrodenanordnung verbundene Steuerschaltung umfasst.

Ein kapazitiver Annäherungssensor der eingangs genannten Art kann beispielsweise als Annäherungssensor zum Auslösen eines Öffnens einer Heckklappe eines Kraftfahrzeugs verwendet werden. Zu diesem Zweck ist eine langgestreckte Sensorelektrodenanordnung mit der Sensorelektrode in einem unteren Bereich des Stoßfängers oder der Fahrzeugschürze am Heck des Kraftfahrzeugs unterhalb der Heckklappe angeordnet. Wenn ein Bediener die Heckklappe zu öffnen wünscht, bewegt er beispielsweise seinen Fuß in Fahrtrichtung unter dem Stoßfänger bzw. die Fahrzeugschürze. Die langgestreckte Sensorelektrodenanordnung ist quer zur Fahrrichtung beispielsweise hinter der Kunststoffverkleidung des Stoßfängers, das heißt hinter der Fahrzeugschürze aus Kunststoffmaterial, angeordnet. Durch die Bewegung des Fußes unter die Fahrzeugschürze mit dem Annäherungssensor wird das von dem kapazitiven Annäherungssensor erzeugte elektrische Feld beeinflusst, so dass sich die Kapazität ändert. Die sich ändernde Kapazität wird mit Hilfe einer Steuerschaltung erfasst, welche hochfrequent periodisch (beispielsweise bei einer Frequenz von 1 MHz) in einem ersten Abschnitt der Periode die Kapazität der Sensorelektrode auf ein vorgegebenes erstes Potenzial, beispielsweise auf eine Spannung von 2,5 V gegenüber Masse, auflädt und welche in einem zweiten Abschnitt der Periode jeweils die Sensorelektrode mit einem Kondensator koppelt, wobei auf der Sensorelektrode akkumulierte Ladung dann auf den Kondensator übertragen wird. Dies wird häufig wiederholt, so dass sich zunehmend mehr Ladung auf dem Kondensator ansammelt, wobei dies beispielsweise solange wiederholt wird, bis die auf dem Kondensator angesammelte Ladung zu einer Spannung führt, die einen vorgegebenen Schwellwert überschreitet. Die Anzahl der hierfür erforderlichen Ladevorgänge, das heißt die Anzahl der Perioden des Aufladens und Ladung-Übertragens, hängt von der Kapazität der Sensorelektrode ab, wobei sich Änderungen dieser Kapazität in Änderungen der Anzahl der Ladeperioden bis zum Erreichen der vorgegebenen Schwellenspannung bemerkbar machen.

Die Steuerschaltung kann beispielsweise einen Mikrocontroller umfassen, wobei ein erster Port des Mikrocontrollers mit der Sensorelektrode gekoppelt sein kann, wobei dieser erste Port die Sensorelektrode periodisch auf die Betriebsspannung (von beispielsweise 2,5 V) schaltet. An diesen ersten Port bzw. an die Sensorelektrode ist der Kondensator angekoppelt, wobei der zweite Anschluss des Kondensators an einen zweiten Port des Controllers angekoppelt sein kann, der diesen Anschluss periodisch auf Masse schaltet. Die Schalter der beiden Ports werden wechselseitig geöffnet und geschlossen, wobei gleichzeitig in einer Messphase die über dem Kondensator anliegende Spannung über die beiden Ports gemessen werden kann. Diese Schaltungsanordnung weist eine Vielzahl parasitärer Kapazitäten auf, beispielsweise Kapazitäten der Ports gegenüber Masse und Kapazitäten der Sensorelektrode und deren Zuleitung gegenüber Masse. Diese parasitären Kapazitäten führen zu einer Verschlechterung der Empfindlichkeit des Annäherungssensors, was letztendlich dazu führen kann, dass die Annäherung eines Fußes des Bedieners nicht mehr mit der erforderlichen Sicherheit erfasst werden kann.

Zur Erhöhung der Empfindlichkeit des kapazitiven Annäherungssensors und teilweise zum Erzielen einer Richtwirkung kann die Sensorelektrodenanordnung eine Hilfselektrode umfassen, die beispielsweise als Schirmelektrode ausgebildet sein kann. Das Potenzial der Hilfselektrode wird teilweise dem Potenzial der Sensorelektrode nachgeführt, wobei insbesondere die Hilfselektrode während des Periodenintervalls, in dem die Sensorelektrode auf die Betriebsspannung (von zum Beispiel 2,5 V) geschaltet wird, auch die Hilfselektrode bzw. die Schirmelektrode auf diese Betriebsspannung gelegt wird. Auch dieser hinzugefügte Schaltungsteil einschließlich der Hilfselektrode und deren Zuleitungen weist parasitäre Kapazitäten auf. Insgesamt kann trotz des Hinzufügens der Hilfselektrode der Fall eintreten, dass die Annäherung des Fußes eines Bedieners bei einem hinter der Fahrzeugschürze angeordneten Sensor nicht ausreichend sicher erfasst wird. Es hat sich gezeigt, dass dies insbesondere dann der Fall ist, wenn im Betrieb eines Kraftfahrzeugs eine Kontamination mit Schmutz, Salz und Feuchtigkeit auftritt, welche zu einer leitenden Schicht sowohl auf der Außenseite des Stoßfängers bzw. der Fahrzeugschürze als auch auf deren Innenfläche, auf der die Sensorelektrodenanordnung aufgebracht ist, führt. Insbesondere zeigt sich dieser nachteilige Effekt bei einer auf der Fahrzeugschürze rückseitig aufgebrachten Sensorelektrodenanordnung, die die Form eines Koaxialkabels aufweist, wobei der Innenleiter der Koaxialanordnung als Hilfselektrode und die Ummantelung als Sensorelektrode verwendet wird. Eine solche Sensorelektrodenanordnung wird allerdings aus Kostengründen bevorzugt.

Aufgabe der Erfindung ist es daher, einen kapazitiven Annäherungssensor zu schaffen, der insbesondere für die Anwendung als "Fußschalter" zum Auslösen des Öffnens einer Heckklappe eines Kraftfahrzeugs bei einer Montage auf der Rückseite einer Fahrzeugschürze bzw. eines Stoßfängers im unteren Bereich des Hecks des Kraftfahrzeugs geeignet ist.

Aus EP 1 600 336 A1 ist es bekannt, in einem Stoßfänger eines Kraftfahrzeugs ein sich über die Breite des Kraftfahrzeugs in einer Nut des Stoßfängers erstreckendes Strahlungselement zum Abstrahlen elektromagnetischer Wellen unterzubringen, das aus einem mit einem elektronischen Bauelement verbundenen Koaxialkabel gebildet wird.

Die oben genannte Aufgabe wird erfindungsgemäß durch einen kapazitiven Annäherungssensor mit den Merkmalen des Anspruchs 1 gelöst. Der kapazitive Annäherungssensor, der hinter einer Verkleidung aus einem Isoliermaterial (das heißt einem Dielektrikum) angeordnet ist und zur Erfassung der Annäherung eines Objekts (beispielsweise eines Körperteils, insbesondere des Fußes eines Bedieners) dient, das sich in einem Erfassungsraum vor der Verkleidung (das heißt beispielsweise der Fahrzeugschürze) befindet, also beispielsweise der Fußschalter zum Auslösen einer Heckklappenöffnung, umfasst eine langgestreckte Sensorelektrodenanordnung mit wenigstens einer Sensorelektrode und wenigstens einer in einem vorgegebenen Mindestabstand parallel zu der Sensorelektrode geführten Hilfselektrode. Unter "parallel geführt" soll hier weniger eine streng geometrisch parallele Anordnung, als vielmehr der parallele Verlauf zweier Elektroden in Längserstreckung der Sensorelektrodenanordnung verstanden werden. Die wenigstens eine Sensorelektrode und die wenigstens eine Hilfselektrode können parallel geführte Drähte, parallel geführte Platten, miteinander verdrillte Drähte oder koaxiale Anordnungen sein, um einige Beispiele zu nennen. Der kapazitive Annäherungssensor weist eine mit der Sensorelektrodenanordnung verbundene Steuerschaltung auf, die hochfrequent periodisch (i) in einem ersten Abschnitt der Periode die Sensorelektrode mit einem vorgegebenen ersten Potenzial koppelt, wobei Ladung auf die Sensorelektrode übertragen wird, (ii) in einem zweiten Abschnitt der Periode die Sensorelektrode mit einem Kondensator koppelt, wobei auf der Sensorelektrode akkumulierte Ladung (ganz oder teilweise) auf den Kondensator übertragen wird, und (iii) zumindest in einem überwiegenden Teil des ersten Abschnitts (das heißt im gesamten Abschnitt oder einem überwiegenden Teil davon) die Hilfselektrode mit einem vorgegebenen zweiten Potenzial koppelt, wobei der Betrag des zweiten Potenzials nicht kleiner als der des ersten Potenzials ist und die Potenziale das gleiche Vorzeichen haben. Die hier vorgesehene Periodendauer entspricht einer Frequenz im Bereich von 100 kHz bis 100 MHz, wobei die Frequenz bei den hier üblichen Kapazitäten einerseits hoch genug sein muss, um eine sichere Messung zu gewährleisten, andererseits aber ausreichend unter der Taktfrequenz der Steuerschaltung (die beispielsweise einen Mikrocontroller enthält) bleiben sollte, um eine gute Steuerbarkeit zu gewährleisten. Beispielsweise wird eine Frequenz von 1 MHz verwendet. Die Sensorelektrodenanordnung ist von einer Abdeckung aus einem Isolatormaterial abgedeckt, wobei die Abdeckung an der rückseitigen Oberfläche der Verkleidung (das heißt beispielsweise der Fahrzeugschürze) derart anliegt, dass die Sensorelektrode hermetisch von den Isolatormaterialien der Verkleidung und der Abdeckung umschlossen ist. "Hermetisch" meint hier insbesondere schmutz- und wasserdicht. Die Sensorelektrodenanordnung ist derart angeordnet, dass die Abstände der Sensorelektrode von den äußeren Oberflächen der Abdeckung und der frontseitigen Oberfläche der Verkleidung jeweils mindestens 5 mm, vorzugsweise mindestens 10 mm, beispielsweise mindestens 15 mm, betragen.

Es hat sich gezeigt, dass durch diese zusätzliche Beabstandung der genannten Oberflächen von der Sensorelektrode, eine zuverlässige Funktion gewährleistet werden kann. Bei diesen Oberflächen handelt es sich um eine solche, die durch Feuchtigkeit und Schmutz (einschließlich Streusalz) verschmutzt werden können, auf denen sich somit ein elektrisch leitfähiger Belag ausbilden kann, der beispielsweise mit Masse gekoppelt ist. Durch die erfindungsgemäße Beabstandung werden ein Teil der störenden (parasitären) Kapazitäten gemindert.

Bei einer bevorzugten Ausführungsform des erfindungsgemäßen kapazitiven Annäherungssensors ist der Abstand der Sensorelektrode von der äußeren Oberfläche der Abdeckung um den Faktor 1,5 bis 4 größer als der Abstand der Sensorelektrode von der frontseitigen Oberfläche der Verkleidung. Durch diese Asymmetrie wird eine sich insbesondere bei verschmutzten Oberflächen auswirkende Richtwirkung einer verbesserten Sensorempfindlichkeit in Richtung des Erfassungsraums vor der Frontseite der Verkleidung (das heißt der Fahrzeugschürze bzw. des Stoßfängers) erzielt.

Eine weitere bevorzugte Ausführungsform des Annäherungssensors ist dadurch gekennzeichnet, dass die Sensorelektrodenanordnung beabstandet von der rückseitigen Oberfläche der Verkleidung angeordnet ist. Bei üblichen Schichtdicken der für diese Verkleidung verwendeten Isolatormaterialien von beispielsweise 3 bis 8 mm ist es vorzugsweise vorgesehen, dass der Abstand der Sensorelektrodenanordnung von der rückseitigen Oberfläche der Verkleidung 2 bis 20 mm, vorzugsweise 5 bis 10 mm, beträgt. Dies verbessert die Empfindlichkeit des Sensors insbesondere dann, wenn die frontseitige Oberfläche der Verkleidung verschmutzt und feucht ist. Eine vorteilhafte Ausführungsform dieser Weiterbildung ist dadurch gekennzeichnet, dass der Abstand der Sensorelektrode von der äußeren Oberfläche der Abdeckung 10 bis 100 mm, vorzugsweise 15 bis 50 mm, beträgt. Das heißt, der Abstand der Sensorelektrode zur äußeren Oberfläche der Abdeckung ist vorzugsweise um einen Faktor zwischen 2 und 5 größer als der Abstand der Sensorelektrodenanordnung von der rückseitigen Oberfläche der Verkleidung. Diese bevorzugte Ausführungsform kombiniert den Vorteil einer Richtwirkung mit geringen parasitären Kapazitäten bei verschmutzten äußeren Oberflächen. Die konkrete Wahl der Abstände hängt selbstverständlich von weiteren konstruktiven Gegebenheiten ab, insbesondere von dem verbleibenden Bauraum zwischen der rückseitigen Oberfläche der Verkleidung (beispielsweise der Fahrzeugschürze oder des Stoßfängers) und den dahinter angeordneten Bauteilen, wie beispielsweise der Fahrzeugkarosserie.

Eine bevorzugte Ausführungsform des kapazitiven Annäherungssensors ist dadurch gekennzeichnet, dass die Sensorelektrodenanordnung von einer beabstandeten Abdeckung derart umgeben ist, dass sich die Sensorelektrode innerhalb eines zwischen Abdeckung und rückseitiger Oberfläche der Verkleidung gebildeten Hohlraums erstreckt, wobei der Hohlraum mit einem Dielektrikum mit einer relativen Dielektrizitätskonstante von annähernd 1 gefüllt ist. Beispielsweise ist der Hohlraum im Wesentlichen mit Luft gefüllt. Der Hohlraum kann aber auch beispielsweise mit einem Schaumstoff gefüllt sein, der im Wesentlichen Luft oder ein anderes Gas enthaltende Poren enthält, so dass die relative Dielektrizitätskonstante des Schaumstoffs sich 1 annähert. Es hat sich gezeigt, dass insbesondere diese Ausführungsform zu einer besseren Empfindlichkeit des Sensors im eingangs genannten Anwendungsfall führt. Die Kombination eines die Elektrodenanordnung umgebenden Hohlraums mit geringer Dielektrizitätskonstante und eine um den Hohlraum geschlossene Umhüllung aus einem Dielektrikum oder mehreren Dielektrika, deren äußere Oberflächen ggf. verschmutzt werden können, schafft einen ausreichend empfindlichen Annäherungssensors auch bei starker Verschmutzung der Oberflächen.

Eine Weiterbildung des kapazitiven Annäherungssensors nach einer der oben genannten Ausführungsformen ist dadurch gekennzeichnet, dass auf oder benachbart zu der äußeren Oberfläche der Abdeckung eine elektrisch leitende Schicht oder Platte angeordnet ist, die mit einem konstanten Potenzial, vorzugsweise mit Massepotenzial, gekoppelt ist. Beispielsweise könnte die äußere Oberfläche der Abdeckung mit einer Metallschicht bedeckt sein, die mit Masse, das heißt mit der Fahrzeugkarosserie beispielsweise, gekoppelt ist. Anstelle einer Beschichtung der äußeren Oberfläche der Abdeckung kann auch das Aufsetzen einer separaten metallischen Kappe vorgesehen sein.

Bei einer Ausführungsform ist der kapazitive Annäherungssensor dadurch gekennzeichnet, dass die Sensorelektrodenanordnung eine koaxiale Elektrodenanordnung mit einem als Hilfselektrode dienenden Innenleiter und einer als Sensorelektrode dienenden, durch ein Isolatormaterial vom Innenleiter getrennten zylindrischen Außenhülle ist. Die koaxiale Elektrodenanordnung hat vorzugsweise einen Durchmesser von 5 bis 8 mm. Eine solche Abmessung der koaxialen Elektrodenanordnung in Kombination mit den eingangs genannten Mindestabständen von 5 mm, vorzugsweise 10 mm, führt zu dem gewünschten Ergebnis. Vorzugsweise sollten die Abstände zwischen der Sensorelektrode und den Außenflächen mindestens dem Durchmesser der Sensorelektrode entsprechen. Die koaxiale Elektrodenanordnung hat zudem den Vorteil, preiswert zur Verfügung zu stehen. Bei einer solchen koaxialen Elektrodenanordnung ist der Raum zwischen dem Innenleiter und der leitenden Außenhülle durch ein Dielektrikum gefüllt. Dasselbe oder eine anderes Dielektrikum umhüllt vorzugsweise auch den Außenleiter und dient zugleich als Schutzschicht. Trotz des Umstands, dass sich die Hilfselektrode vollständig im Inneren der Sensorelektrode befindet, sorgt die Beaufschlagung dieser Hilfselektrode mit einem Potenzial, das gleich oder größer als das Potenzial der Sensorelektrode in einem ersten Abschnitt der Periode, in dem die Ladung auf der Sensorelektrode angesammelt wird, für eine höhere Empfindlichkeit der Sensoranordnung.

Sofern neben der Erhöhung der Empfindlichkeit durch die Verwendung der Hilfselektrode auch zusätzlich eine Erzielung einer Richtwirkung gewünscht ist, kann bei einer alternativen Ausführungsform vorgesehen sein, dass die Sensorelektrode und die Hilfselektrode in einem vorgegebenen Abstand und einer vorgegebenen Orientierung derart nebeneinander angeordnet sind, dass die Sensorelektrode zwischen der rückseitigen Oberfläche der Verkleidung und der Hilfselektrode angeordnet ist, so dass die Hilfselektrode einen rückseitigen Schirm für die Sensorelektrode bildet. Vorzugsweise ist der so gestaltete Annäherungssensor zwischen einem mit Masse gekoppelten Bauteil (beispielsweise der Kraftfahrzeugkarosserie) und der rückseitigen Oberfläche der Verkleidung (beispielsweise der Fahrzeugschürze) angeordnet, so dass die den Schirm bildende Hilfselektrode zwischen der Sensorelektrode und dem mit Masse gekoppelten Bauteil angeordnet ist.

Zusätzlich kann bei einer Ausführungsform vorgesehen sein, dass die Sensorelektrodenanordnung eine Masseelektrode umfasst, die so angeordnet ist, dass die den Schirm bildende Hilfselektrode zwischen dieser Masseelektrode und der Sensorelektrode angeordnet ist. Zur Erzielung bestimmter Richtwirkungen können auch kompliziertere Elektrodenanordnungen mit mehreren Masse-, Hilfs- und Sensorelektroden vorgesehen sein. Es kann auch vorgesehen sein, dass die relative Anordnung der parallel geführten Sensorelektrode und Hilfselektrode sich entlang der langgestreckten Sensoranordnung ändert. Dies ist beispielsweise dann der Fall, wenn Sensorelektrode und Hilfselektrode aus jeweils einem Draht gebildet sind und miteinander beabstandet verdrillt sind. Durch eine solche oder eine andere wechselnde Anordnung von Hilfselektrode und Sensorelektrode kann beispielsweise eine sich entlang der Elektrodenanordnung ändernde Richtcharakteristik erreicht werden. Dies ermöglicht - bei geeigneter Auswertung durch die Steuerschaltung - eine Erfassung der Bewegung eines Objekts, beispielsweise eines Bedienerkörperteils (zum Beispiel Fuß), in Längsrichtung entlang der Sensorelektrodenanordnung. Die zusätzliche Erfassung einer Bewegungsrichtung des Objekts kann beispielsweise zu zusätzlichen Steuerfunktionen, die durch die Sensoranordnung ausgelöst werden sollen, verwendet werden.

Vorteilhafte und oder bevorzugte Weiterbildungen der Erfindung sind in den Unteransprüchen gekennzeichnet.

Im Folgenden wird die Erfindung anhand von in den Zeichnungen dargestellten bevorzugten Ausführungsformen näher erläutert. In den Zeichnungen zeigen:
Figur 1 eine schematische Schnittdarstellung einer ersten Ausführungsform des erfindungsgemäßen kapazitiven Annäherungssensors;
Figur 2 eine schematische Schnittdarstellung einer alternativen Ausführungsform des Annäherungssensors;
Figur 3 eine schematische Darstellung der Anordnung der Sensorelektrodenanordnung und der Steuerschaltung auf der Rückseite eines Stoßfängers eines Kraftfahrzeugs; und
Figur 4 eine schematische Blockdarstellung eines Teils der Steuerschaltung mit angekoppelter Sensorelektrodenanordnung.

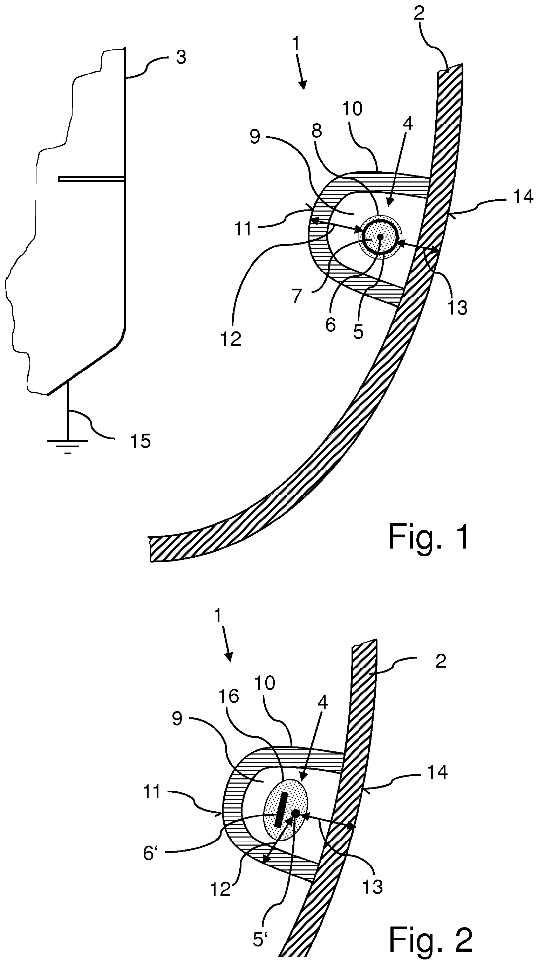

Figur 1 zeigt eine schematische Darstellung des erfindungsgemäßen kapazitiven Annäherungssensors 1, der hinter einer Fahrzeugschürze 2, also in einem zwischen der Fahrzeugschürze 2 und der Karosserie 3 eines Kraftfahrzeugs vorhandenen Einbauraum, montiert ist. Der kapazitive Annäherungssensor 1 umfasst eine langgestreckte Sensorelektrodenanordnung 4, die auf der Rückseite der Fahrzeugschürze 2 im Heckbereich des Fahrzeugs quer zur Fahrtrichtung in einer vorgegebenen Höhe über dem Boden befestigt ist und sich über einen Teil der Breite des Kraftfahrzeugs erstreckt. Der kapazitive Annäherungssensor umfasst ferner eine in Figur 1 nicht dargestellte Steuerschaltung zur Ansteuerung und zur Auswertung des Sensors.

Die Sensorelektrodenanordnung 4 umfasst eine Sensorelektrode 5 und eine Hilfselektrode 6. Die Sensorelektrodenanordnung 4 ist bei dem in Figur 1 dargestellten Ausführungsbeispiel in einer koaxialen Form ausgeführt. Das heißt, der Innenleiter eines Koaxialkabels bildet die Hilfselektrode 6, während die beabstandete Leiterummantelung die Sensorelektrode 5 darstellt. Zwischen Innenleiter-Hilfselektrode 6 und Außenmantel-Sensorelektrode 5 ist ein Dielektrikum 7 eingebracht. Darüber hinaus wird die Außenleiter-Ummantelung der Sensorelektrode 5 durch einen Mantel 8 aus einem Isolatormaterial geschützt.

Die auf der Rückseite der Fahrzeugschürze 2 montierte Sensorelektrodenanordnung 4 ist von einer Abdeckung 10 aus einem Isolatormaterial (Dielektrikum), beispielsweise aus Kunststoff, abgedeckt. Die Abdeckung 10 liegt derart an der rückseitigen Oberfläche der Fahrzeugschürze 2 an, dass die Sensorelektrodenanordnung 4 hermetisch, das heißt schmutz- und wasserdicht, von den Isolatormaterialien der Fahrzeugschürze 2 und der Abdeckung 10 umschlossen ist. Die Abdeckung 10 ist beispielsweise auf der Innenseite der Fahrzeugschürze 2 aufgeklebt. Im Fahrzeugbetrieb gelangen Schmutz, Salze und/oder Feuchtigkeit sowohl auf die Außenfläche 14 der Fahrzeugschürze 2 als auch auf deren Rückseite und somit auch auf die Oberfläche 11 der Abdeckung 10, können aber nicht in den Innenraum 9 der Abdeckung 10 eindringen, in dem die Sensorelektrodenanordnung 4 montiert ist.

Die Sensorelektrodenanordnung 4 ist sowohl beabstandet von der rückseitigen Oberfläche der Fahrzeugschürze 2 als auch beabstandet von dem Material der Abdeckung 10 im Innenraum 9 angeordnet. Die dazu erforderlichen Montageelemente und Halterungen sind in Figur 1 nicht dargestellt. Der Hohlraum 9 kann sowohl Luft als auch einen Schaumstoff mit etwa vergleichbarer Dielektrizitätskonstante enthalten. In dem zuletzt genannten Fall kann der Schaumstoff zugleich zum Halten der Elektrodenanordnung 4 verwendet werden.

Die Fahrzeugschürze 2 hat in dem Abschnitt, in dem rückseitig die Sensorelektrodenanordnung 4 und die Abdeckung 10 montiert sind, beispielsweise eine Dicke von 3 bis 8 mm. Die Abmessungen der Abdeckung 10 und die Anordnung der Sensorelektroden 4 sind so gewählt, dass der Abstand 13 zwischen der Sensorelektrode 5 und der frontseitigen Oberfläche 14 der Fahrzeugschürze 2 zwischen 8 und 15 mm beträgt, während der Abstand 12 zwischen der Sensorelektrode 5 und der Außenfläche 11 der Abdeckung 10 bei etwa dem 1,5-fachen bis 3-fachen dieser Abmessung liegt. Die Dicke der Wandung der Abdeckung 10 liegt beispielsweise bei 2 bis 5 mm. Der Durchmesser der koaxialen Sensoranordnung 4 liegt zwischen 6 und 8 mm.

In Abhängigkeit von der gewünschten Empfindlichkeit, der gewählten Frequenz der periodischen Umschaltung der Sensorelektrodenanordnung, den verwendeten Materialien und dem zwischen der Fahrzeugschürze 2 und der Karosserie 3 zur Verfügung stehenden Einbauraum können die genannten Abmessungen im Rahmen der in den Ansprüchen angegebenen Bereiche variieren.

Figur 2 zeigt eine schematische Darstellung eines Ausschnitts der in Figur 1 gezeigten Anordnung mit einer alternativen Ausführungsform der Sensorelektrodenanordnung 4. Bei dem Ausführungsbeispiel gemäß Figur 2 werden dieselben Bezugsziffern wie bei dem Ausführungsbeispiel gemäß Figur 1 für gleiche Elemente verwendet. Die Sensorelektrodenanordnung 4 umfasst wiederum eine Steuerelektrode 5' und eine Hilfselektrode 6'. Bei dieser Ausführungsform ist die Hilfselektrode 6' als Schirmelektrode ausgebildet. Die Schirmelektrode 6' stellt eine metallische Platte dar, die in einem geringen Abstand neben der Sensorelektrode 5' angeordnet ist. Dabei befindet sich die Schirmelektrode 6' zwischen der in Figur 2 nicht dargestellten Karosserie 3, welche mit Masse 15 gekoppelt ist (vgl. Figur 1), und der Sensorelektrode 5'. Die parallel geführten Elektroden 5' und 6' sind von einer Kunststoffummantelung 16 umschlossen und in dem Hohlraum 9 montiert, der zwischen der Abdeckung 10 und der rückseitigen Oberfläche der Fahrzeugschürze 2 gebildet ist.

Bei der in Figur 2 gezeigten Anordnung der Schirmelektrode und der Sensorelektrode 5' wird eine Richtwirkung hinsichtlich der Ansprechempfindlichkeit der Sensoranordnung erreicht. Die Schirmelektrode 6', welche in den Messintervallen (beim Aufladen der zwischen der Sensorelektrode 5' und Masse gebildeten Kapazität) auf das Potenzial der Sensorelektrode gebracht wird, sorgt dafür, dass die Sensoranordnung in Richtung der Karosserie 3 abgeschirmt wird, so dass insbesondere Änderungen des elektrischen Feldes vor der Oberfläche 14 der Fahrzeugschürze 2, welche durch ein Eindringen eines Bedienerkörperteils verursacht werden, sich auf die Änderung der Kapazität der Sensorelektrode 5' gegenüber Masse auswirken.

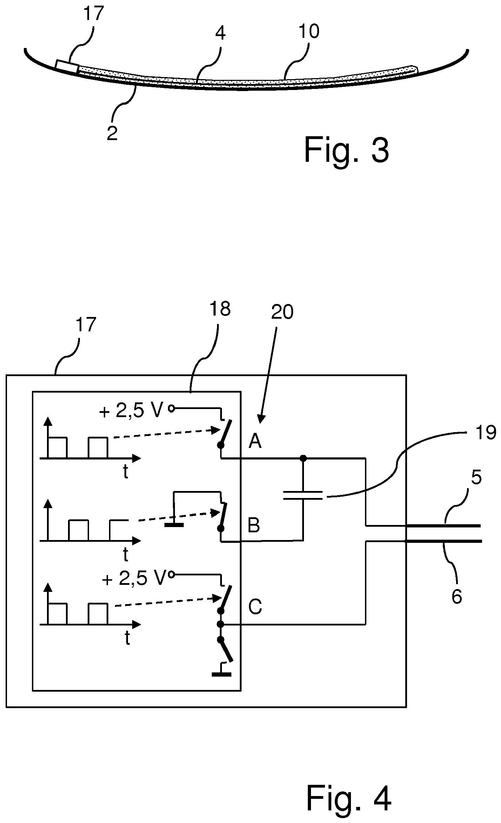

Figur 3 zeigt eine schematische Draufsicht auf einen Ausschnitt der Fahrzeugschürze, an dem rückseitig der kapazitive Annäherungssensor befestigt ist. Figur 3 zeigt schematisch die Sensorelektrodenanordnung 4 innerhalb der Abdeckung 10 und die Kopplung der Sensorelektrodenanordnung 4 mit der Steuerschaltung 17. Die Steuerschaltung 17 ist ebenfalls an der Rückseite der Fahrzeugschürze 2 befestigt. Die Zuleitungen für die Spannungsversorgung und die Signalübertragung sind nicht dargestellt.

Figur 4 zeigt eine schematische Darstellung eines Teils der Schaltung der Steuerschaltung 17, die sowohl mit der Sensorelektrode 5 als auch mit der Hilfselektrode 6 gekoppelt ist. Bei dem in Figur 4 dargestellten Ausführungsbeispiel enthält die Steuerschaltung 17 einen Mikrocontroller 18 mit mehreren Ports 20 (A, B und C), die jeweils sowohl der Ausgabe von Signalen als auch als Eingänge des Mikrocontrollers 18 dienen können. Die Sensorelektrode 5 ist mit einem ersten Port A gekoppelt. Zwischen diesem Port A und einem Port B ist ein Kondensator 19 eingekoppelt. Der Kondensator 19 weist eine wesentlich höhere Kapazität als die Summe der Kapazität der Sensorelektrode und sämtlicher parasitärer Kapazitäten auf. Beispielsweise hat der Kondensator 19 eine Kapazität von 300 nF. Die Hilfselektrode 6 ist mit einem dritten Port C gekoppelt.

Wie es schematisch innerhalb des den Mikrocontroller 18 darstellenden Kastens in Figur 4 angedeutet ist, ist innerhalb des Mikrocontrollers ein Schalter vorgesehen, der den Port A und somit die Sensorelektrode 5 auf eine Versorgungsspannung von beispielsweise 2,5 V legen kann. Ferner ist am Port B ein Schalter vorgesehen, der diesen Portanschluss auf Masse schalten kann. Am Port C schließlich ist ebenfalls ein Schalter vorgesehen, der diesen Port ebenfalls auf die Versorgungsspannung von 2,5 V schalten kann, sowie ein weiterer Schalter, der den Port C auf Masse legen kann. In Zuordnung zu diesen Schaltern sind schematische Zeitdiagramme abgebildet, die jeweils das Einschalten der Schalter mit einem hohen Pegel und das Ausschalten mit einem niedrigen Pegel darstellen. Die drei Diagramme sind einander zeitlich zugeordnet, so dass man erkennen kann, dass dann, wenn der Mikrocontroller 18 dem Port A auf Versorgungsspannung schaltet, der Schalter des Ports B geöffnet wird, und dann, wenn der Schalter des Ports A geöffnet ist, der Port B auf Masse gelegt wird. Dieses mehrfache Umschalten der Schalter A und B erfolgt beispielsweise mit einer Frequenz von 1 MHz, so dass die Schalter der Ports A und B jeweils abwechselnd für 500 ns eingeschaltet bleiben. Der obere Schalter am Port C wird in etwa synchron zum Schalter am Port A geschaltet, so dass die mit dem Port C verbundene Hilfselektrode 6 immer dann auf das Potenzial der Sensorelektrode 5 gelegt wird, wenn die Sensorelektrode 5 durch Schließen des Schalters am Port A auf 2,5 V aufgeladen wird. In einem ersten Abschnitt einer Periode des Umschaltens, in dem der Schalter am Port A geschlossen und der Schalter am Port B geöffnet sind, wird somit die von der Sensorelektrode 5 gebildete Kapazität auf eine Spannung von 2,5 V aufgeladen, so dass ein von dieser Kapazität abhängige Ladungsmenge auf die Sensorelektrode 5 (und selbstverständlich auf deren Zuleitungen und deren parasitäre Kapazitäten) fließt. In einem darauffolgenden zweiten Teilintervall, in dem der Schalter am Port A geöffnet und der Schalter am Port B geschlossen wird, wird die von der Sensorelektrode 5 gegenüber Masse gebildete Kapazität in Reihe zum Kondensator 19 geschaltet, dessen anderer Anschluss mit Masse gekoppelt wird. Dabei fließt ein Teil der auf der Sensorelektrode 5 während des Aufladens angesammelten Ladung auf den Kondensator 19 ab, so dass dieser weiter aufgeladen wird und sich die Spannung über dem Kondensator 19 der Versorgungsspannung von 2,5 V annähert. Bei jedem Zyklus wird der Kondensator 19 ein Stück mehr aufgeladen, so dass sich die Spannung über diesem Kondensator immer weiter der Spannung von 2,5 V annähert. Selbstverständlich müssen die Schalter an den Ports A und B so geschaltet werden, dass niemals beide Schalter gleichzeitig geschlossen sind.

Die hier beschriebene Funktionsweise ist teilweise vereinfacht dargestellt. Tatsächlich muss der Mikrocontroller nach Öffnen des Schalters am Port A und dem Übertragen der Ladung von der Sensorelektrode 5 auf den Kondensator 19 durch Schließen des Schalters B noch die dann über dem Kondensator 19 entstandene Spannung messen. Zu diesem Zweck ist es erforderlich, dass der Port A mit dem Eingang eines Analog/Digital-Umsetzers gekoppelt wird, welcher sich in dem Mikrocontroller 18 befindet. Die Ausgabe dieses Analog/Digital-Umsetzers ist schließlich mit Hilfe eines Komparators mit einem Referenzwert zu vergleichen. Ferner enthält der Mikrocontroller Einrichtungen, welche dazu dienen, die Anzahl der Zyklen bis zum Erreichen dieser vorgegebenen Spannung zu zählen, das Ergebnis auszuwerten und den Gesamtablauf zu steuern. Darüber hinaus können weitere Ports des Mikrocontrollers 18 mit den Elektroden gekoppelt sein, die im Rahmen eines von dem Programm des Mikrocontrollers gesteuerten Mess- und Auswertungsablaufs weitere Vorspannungen auf die Elektroden legen oder zum Entladen der Kapazitäten dienen.

## Patentansprüche

1. Kapazitiver Annäherungssensor (1), der hinter einer Verkleidung (2) aus einem Isolatormaterial angeordnet ist und zur Erfassung der Annäherung eines Objekts dient, das sich in einem Erfassungsraum vor der Verkleidung (2) befindet, wobei der Annäherungssensor (1) aufweist:
eine langgestreckte Sensorelektrodenanordnung (4) mit wenigstens einer Sensorelektrode (5) und wenigstens einer in einem vorgegebenen Mindestabstand parallel zu der Sensorelektrode (5) geführten Hilfselektrode (6), und
eine mit der Sensorelektrodenanordnung (4) verbundene Steuerschaltung (17), die hochfrequent periodisch mit einer Frequenz im Bereich von 100 kHz und 100 MHz
- in einem ersten Abschnitt der Periode die Sensorelektrode (5) mit einem vorgegebenen ersten Potential koppelt, wobei Ladung auf die Sensorelektrode (5) übertragen wird,
- in einem zweiten Abschnitt der Periode die Sensorelektrode (5) mit einem Kondensator (19) koppelt, wobei auf der Sensorelektrode (5) akkumulierte Ladung auf den Kondensator (19) übertragen wird, und
- zumindest in einem überwiegenden Teil des ersten Abschnitts die Hilfselektrode (6) mit einem vorgegebenen zweiten Potential koppelt, wobei der Betrag des zweiten Potentials nicht kleiner als der des ersten Potentials ist und die Potentiale das gleiche Vorzeichen haben,
wobei die Sensorelektrodenanordnung (4) von einer Abdeckung (10) aus einem Isolatormaterial abgedeckt ist, wobei die Abdeckung (10) an der rückseitigen Oberfläche der Verkleidung (2) derart anliegt, dass die Sensorelektrodenanordnung (4) hermetisch von den Isolatormaterialien der Verkleidung (2) und der Abdeckung (10) umschlossen ist, und
wobei die Sensorelektrodenanordnung (4) derart angeordnet ist, dass die Abstände (12, 13) der Sensorelektrode (5) von der äußeren Oberfläche (11) der Abdeckung (10) und von der frontseitigen Oberfläche (14) der Verkleidung (2) jeweils mindestens 5 mm, vorzugsweise mindestens 10 mm, betragen.

2. Kapazitiver Annäherungssensor nach Anspruch 1, **dadurch gekennzeichnet, dass** der Abstand (12) der Sensorelektrode (5) von der äußeren Oberfläche (11) der Abdeckung (10) um den Faktor 1,5 bis 4 größer ist als der Abstand (13) der Sensorelektrode (5) von der frontseitigen Oberfläche (14) der Verkleidung (2).

3. Kapazitiver Annäherungssensor nach Anspruch 1 oder 2, **dadurch gekennzeichnet, dass** die Sensorelektrodenanordnung (4) beabstandet von der rückseitigen Oberfläche der Verkleidung (2) angeordnet ist.

4. Kapazitiver Annäherungssensor nach Anspruch 3, **dadurch gekennzeichnet, dass** die Verkleidung (2) eine Dicke von 3 - 8 mm hat, und dass der Abstand der Sensorelektrodenanordnung (4) von der rückseitigen Oberfläche der Verkleidung (2) 2 - 20 mm, vorzugsweise 5 - 10 mm, beträgt.

5. Kapazitiver Annäherungssensor nach Anspruch 4, **dadurch gekennzeichnet, dass** der Abstand (12) der Sensorelektrode (5) von der äußeren Oberfläche (11) der Abdeckung (10) 5 - 100 mm, vorzugsweise 10 - 50 mm, beträgt.

6. Kapazitiver Annäherungssensor nach einem der Ansprüche 3 - 5, **dadurch gekennzeichnet, dass** die Sensorelektrodenanordnung (4) von einer beabstandeten Abdeckung (10) derart umgeben ist, dass sich die Sensorelektrode (5) innerhalb eines zwischen Abdeckung (10) und rückseitiger Oberfläche der Verkleidung (2) gebildeten Hohlraums (9) erstreckt, wobei der Hohlraum (9) mit einem Dielektrikum mit einer relativen Dielektrizitätskonstante von annähernd 1 gefüllt ist.

7. Kapazitiver Annäherungssensor nach Anspruch 6, **dadurch gekennzeichnet, dass** der Hohlraum (9) im Wesentlichen mit Luft gefüllt ist.

8. Kapazitiver Annäherungssensor nach Anspruch 6, **dadurch gekennzeichnet, dass** der Hohlraum (9) mit einem Schaumstoff gefüllt ist.

9. Kapazitiver Annäherungssensor nach einem der Ansprüche 1 - 8, **dadurch gekennzeichnet, dass** auf oder benachbart zu der äußeren Oberfläche (11) der Abdeckung (10) eine elektrisch leitende Schicht oder Platte angeordnet ist, die mit einem konstanten Potential, vorzugsweise mit Massepotential, gekoppelt ist.

10. Kapazitiver Annäherungssensor nach einem der Ansprüche 1 - 9, **dadurch gekennzeichnet, dass** die Sensorelektrodenanordnung (4) eine koaxiale Elektrodenanordnung mit einem als Hilfselektrode (6) dienenden Innenleiter und einer als Sensorelektrode (5) dienenden, durch ein Isolatormaterial (7) vom Innenleiter getrennten zylindrischen Außenhülle ist.

11. Kapazitiver Annäherungssensor nach Anspruch 10, **dadurch gekennzeichnet, dass** der radiale Abstand (12) der Sensorelektrode (5) von der äußeren Oberfläche (11) der Abdeckung (10) mindestens so groß wie der Durchmesser der Sensorelektrode (5) ist.

12. Kapazitiver Annäherungssensor nach Anspruch 10 oder 11, **dadurch gekennzeichnet, dass** die koaxiale Elektrodenanordnung (4) einen Durchmesser von 5 - 8 mm hat.

13. Kapazitiver Annäherungssensor nach einem der Ansprüche 1 - 9, **dadurch gekennzeichnet, dass** die Sensorelektrode (5) und die Hilfselektrode (6) in einem vorgegebenen Abstand und einer vorgegebenen Orientierung derart nebeneinander angeordnet sind, dass die Sensorelektrode (5) zwischen der rückseitigen Oberfläche der Verkleidung (2) und der Hilfselektrode (6) angeordnet ist, so dass die Hilfselektrode (6) einen rückseitigen Schirm bildet.

14. Kapazitiver Annäherungssensor nach Anspruch 13, **dadurch gekennzeichnet, dass** der Annäherungssensor (1) zwischen einem mit Masse (15) gekoppelten Bauteil (3) und der rückseitigen Oberfläche der Verkleidung (2) angeordnet ist, so dass die den Schirm bildende Hilfselektrode (6) zwischen der Sensorelektrode (5) und dem mit Masse gekoppelten Bauteil (3) angeordnet ist.

15. Kapazitiver Annäherungssensor nach Anspruch 13 oder 14, **dadurch gekennzeichnet, dass** die Sensorelektrodenanordnung (4) eine Masseelektrode umfasst, die so angeordnet ist, dass die den Schirm bildende Hilfselektrode (6) zwischen der Masseelektrode und der Sensorelektrode (5) angeordnet ist.

## Claims

1. Capacitive proximity sensor (1) which is arranged behind a cladding (2) made of an insulator material and serves to detect the approaching of an object which is a detection area in front of the cladding (2), wherein the proximity sensor (1) comprises
an elongated senor electrode arrangement (4) with at least one sensor electrode (5) and arranged at a predefined minimum distance in parallel to the sensor electrode (5) at least one auxiliary electrode (6), and
with, connected to the sensor electrode arrangement (4), a control circuit (17), which at high frequency periodically with a frequency in the range of 100 kHz and 100 MHz
- in a first section of the period connects the sensor electrode (5) with a predetermined first potential, wherein a charge is transferred to the sensor electrode (5),
- in a second section of the period connects the sensor electrode (5) to a capacitor (19), wherein a charge accumulated on the sensor electrode (5) is transferred to the capacitor (19), and
- at least in a predominant part of the first section connects the auxiliary electrode (6) to a predefined second potential, wherein the value of the second potential is not smaller than the first potential and the potentials have the same plus or minus sign
wherein the sensor electrode arrangement (4) is covered by a cover (10) made of insulator material, wherein the cover (10) is in contact with the rear surface of the cladding (2) in such a way that the sensor electrode arrangement (4) is hermetically encompassed by the insulating material of the cladding (2) and the cover (10), and
wherein the sensor electrode arrangement (4) is arranged in such a way that the distances (12, 13) of the sensor electrodes (5) from the outer surface (11) of the cover (10) and from the front surface (14) of the cladding (2) are each at least 5 mm, preferably at least 10 mm.

2. Capacitive proximity sensor according to claim 1 **characterised in that** the distance (12) of the sensor electrode (5) from the outer surface (11) of the cladding (10) is greater by a factor of 1.5 to 4 than the distance (13) of the sensor electrode (5) from the front surface (14) of the cladding (2).

3. Capacitive proximity sensor according to claim 1 or 2 **characterised in that** the sensor electrode arrangement (4) is arranged at a distance from the rear surface of the cladding (2).

4. Capacitive proximity sensor according to claim 3 **characterised in that** the cladding (2) has a thickness of 3 - 8 mm and **in that** the distance of the sensor electrode arrangement (4) from the rear surface of the cladding (2) is 2 - 20 mm, preferably 5 - 10 mm.

5. Capacitive proximity sensor according to claim 4 **characterised in that** the distance (12) of the sensor electrode (5) from the outer surface (11) of the cover (10) is 5 - 100 mm, preferably 10 - 50 mm.

6. Capacitive proximity sensor according to any one of claims 3 - 5 **characterised in that** the sensor electrode arrangement (4) is encompassed at a distance by a cover (10) in such a way that the sensor electrode (5) extends within a hollow space (9) formed between the cover (10) and the rear surface of the cladding (2), wherein the hollow space (9) is filled with a dielectric material with a relative dielectric constant of approximately 1.

7. Capacitive proximity sensor according to claim 6 **characterised in that** the hollow space (9) is essentially filled with air.

8. Capacitive proximity sensor according to claim 6 **characterised in that** the hollow space (9) is filled with foam material.

9. Capacitive proximity sensor according to any one of claims 1 - 8 **characterised in** arranged on or adjacent to the outer surface (11) of the cover (10) is an electrically conducting layer or panel which is connected to a constant potential, preferably earth potential.

10. Capacitive proximity sensor according to any one of claims 1 - 9 **characterised in that** the sensor electrode arrangement (4) is a coaxial electrode arrangement with an inner conductor serving as the auxiliary electrode (6) and cylindrical outer casing serving as the sensor electrode (5) and separated from the inner conductor by an insulator material (7).

11. Capacitive proximity sensor according to claim 10 **characterised in that** the radial distance (12) of the sensor electrode (5) from the outer surface (11) of the cover (10) is at least as great as the diameter of the sensor electrode (5).

12. Capacitive proximity sensor according to claim 10 or 11 **characterised in that** the coaxial electrode arrangement (4) has a diameter of 5 - 8 mm.

13. Capacitive proximity sensor according to any one of claims 1 - 9 **characterised in that** the sensor electrode (5) and the auxiliary electrode (6) are arranged next to each other at a predefined distance and with a predefine orientation in such a way that the sensor electrode (5) is arranged between the rear surface of the cladding (2) and the auxiliary electrode (6) so that the auxiliary electrode (6) forms a rear screen.

14. Capacitive proximity sensor according to claim 13 **characterised in that** the proximity sensor (1) is arranged between a component (3) connected to earth (15) and the rear surface of the cladding (2) so that the auxiliary electrode (6) forming the screen is arranged between the sensor electrode (5) and the component connected (3) connected to earth.

15. Capacitive proximity sensor according to claim 13 or 14 **characterised in that** the sensor electrode arrangement (4) comprises an earth electrode which is arranged in such a way that the auxiliary electrode (6) forming the screen is arranged between the earth electrode and the sensor electrode (5).

## Revendications

1. Détecteur d'approche capacitif (1) qui est disposé derrière un revêtement (2) composé d'un matériau isolant et sert à détecter l'approche d'un objet qui se trouve dans un espace de détection situé devant le revêtement (2), le détecteur d'approche (1) présentant :
un dispositif d'électrode de détection à l'extension longitudinale (4) comportant au moins une électrode de détection (5) et au moins une électrode auxiliaire (6) guidée à une distance minimale prédéfinie parallèlement à l'électrode de détection (5), et
un circuit de commande (17) raccordé au dispositif d'électrode de détection (4) et qui, périodiquement à haute fréquence, avec une fréquence de l'ordre de 100 kHz à 100 MHz,
- dans une première section de la période, couple l'électrode de détection (5) à un premier potentiel prédéfini, la charge étant transférée sur l'électrode de détection (5),
- dans une seconde section de la période, couple l'électrode de détection (5) à un condensateur (19), de la charge accumulée sur l'électrode de détection (5) étant transférée au condensateur (19), et
- au moins dans une partie majoritaire de la première section, couple l'électrode auxiliaire (6) à un second potentiel prédéfini, le montant du second potentiel n'étant pas inférieur à celui du premier potentiel et les potentiels ayant le même signe,
le dispositif d'électrode de détection (4) étant recouvert par un recouvrement (10) en matériau isolant, le recouvrement (10) reposant sur la surface arrière du revêtement (2) de manière à ce que le dispositif d'électrode de détection (4) soit entouré hermétiquement par les matériaux isolants du revêtement (2) et le recouvrement (10), et
le dispositif d'électrode de détection (4) étant disposé de manière à ce que les distances (12,13) entre l'électrode de détection (5) et la surface extérieure (11) du recouvrement (10) et la surface avant (14) du revêtement (2) s'élèvent respectivement à 5 mm, de préférence au moins 10 mm.

2. Détecteur d'approche capacitif selon la revendication 1, **caractérisé en ce que** la distance (12) entre l'électrode de détection (5) et la surface extérieure (11) du recouvrement (10) est supérieure du facteur 1,5 à 4 à la distance (13) entre l'électrode de détection (5) et la surface avant (14) du revêtement (2) .

3. Détecteur d'approche capacitif selon la revendication 1 ou 2, **caractérisé en ce que** le dispositif d'électrode de détection (4) est disposé espacé de la surface arrière du revêtement (2).

4. Détecteur d'approche capacitif selon la revendication 3, **caractérisé en ce que** le revêtement (2) a une épaisseur de 3 à 8 mm et que la distance entre le dispositif d'électrode de détection (4) et la surface arrière du revêtement (2) est de 2 à 20 mm, de préférence 5 à 10 mm.

5. Détecteur d'approche capacitif selon la revendication 4, **caractérisé en ce que** la distance (12) entre l'électrode de détection (5) et la surface extérieure (11) du revêtement (10) est de 5 à 100 mm, de préférence 10 à 50 mm.

6. Détecteur d'approche capacitif selon une des revendications 3 à 5, **caractérisé en ce que** le dispositif d'électrode de détection (4) est entouré par un revêtement espacé (10) de manière à ce que l'électrode de détection (5) s'étende dans une cavité (9) constituée entre le revêtement (10) et la surface arrière du revêtement (2), la cavité (9) étant remplie d'un diélectrique ayant une constante de diélectricité relative d'approximativement 1.

7. Détecteur d'approche capacitif selon la revendication 6, **caractérisé en ce que** la cavité (9) est remplie substantiellement d'air.

8. Détecteur d'approche capacitif selon la revendication 6, **caractérisé en ce que** la cavité (9) est remplie de mousse.

9. Détecteur d'approche capacitif selon une des revendications 1 à 8, **caractérisé en ce que**, sur ou à proximité de la surface extérieure (11) du revêtement (10), est disposée une couche ou une plaque conductrice d'électricité qui est couplée à un potentiel constant, de préférence à un potentiel de masse.

10. Détecteur d'approche capacitif selon une des revendications 1 à 9, **caractérisé en ce que** le dispositif d'électrode de détection (4) est un dispositif d'électrode coaxial comportant un conducteur interne servant d'électrode auxiliaire (6) et une enveloppe extérieure cylindrique servant d'électrode de détection (5) et séparée par un matériau isolant (7) du conducteur interne.

11. Détecteur d'approche capacitif selon la revendication 10, **caractérisé en ce que** la distance radiale (12) entre l'électrode de détection (5) et la surface extérieure (11) du recouvrement (10) est au moins égale au diamètre de l'électrode de détection (5).

12. Détecteur d'approche capacitif selon la revendication 10 ou 11, **caractérisé en ce que** le dispositif d'électrode coaxial (4) a un diamètre de 5 à 8 mm.

13. Détecteur d'approche capacitif selon une des revendications 1 à 9, **caractérisé en ce que** l'électrode de détection (5) et l'électrode auxiliaire (6) sont disposées l'une à côté de l'autre à une distance prédéfinie et suivant une orientation prédéfinie de manière à ce que l'électrode de détection (5) soit disposée entre la surface arrière du revêtement (2) et l'électrode auxiliaire (6), de sorte que l'électrode auxiliaire (6) constitue un blindage arrière.

14. Détecteur d'approche capacitif selon la revendication 13, **caractérisé en ce que** le détecteur d'approche (1) est disposé entre une pièce (3) couplée à la masse (15) et la surface arrière du revêtement (2), de sorte que l'électrode auxiliaire (6) constituant le blindage est disposée entre l'électrode de détection (5) et la pièce (3) couplée à la masse.

15. Détecteur d'approche capacitif selon la revendication 13 ou 14, **caractérisé en ce que** le dispositif d'électrode de détection (4) comprend une électrode de masse qui est disposée de manière à ce que l'électrode auxiliaire (6) constituant le blindage soit disposée entre l'électrode de masse et l'électrode de détection (5) .
